# EUROPEAN PATENT APPLICATION

(11) **EP 1 640 342 A1**
(43) Date of publication of application: **29.03.2006**
(21) Application number: 04746061.3
(22) Date of filing: 11.06.2004
(51) Int. Cl.: C01B 33/04, C01B 33/021, H01L 21/208

(54) **SILANE POLYMER AND METHOD FOR FORMING SILICON FILM**

(30) Priority: 13.06.2003 JP 2003169769
(71) Applicant: JSR Corporation, Tokyo 104-0045 (JP)
(72) Inventor: IWASAWA, Haruo, c/o JSR Corporation, Chuo-ku, Tokyo 104-0045 (JP); WANG, Daohai, c/o JSR Corporation, Chuo-ku, Tokyo 104-0045 (JP); MATSUKI, Yasuo, c/o JSR Corporation, Chuo-ku, Tokyo 104-0045 (JP); KATO, Hitoshi, c/o JSR Corporation, Chuo-ku, Tokyo 104-0045 (JP)
(74) Representative: TBK-Patent
(86) International application number: PCT/JP2004/008547
(87) International publication number: WO 2004/110929

(57) **Abstract**

There are provided a silane polymer having a higher molecular weight from the viewpoints of wettability when applied to a substrate, a boiling point and safety, a composition which can form a high-quality silicon film easily, a silicon film forming composition which comprises a silane polymer obtained by irradiating a photopolymerizable silane compound with light of specific wavelength range to photopolymerize it, and a method for forming a silicon film which comprises applying the composition to a substrate and subjecting the coating film to a heat treatment and/or a light treatment.

## Description

### Technical Field

The present invention relates to a silane polymer, a production method thereof, and a method for forming a silicon film. More specifically, the present invention relates to a silane polymer which is applied to applications such as an integrated circuit, a thin-film transistor, a photoelectric converter and a photoreceptor, a production method of the polymer, and a method for forming a high-quality silicon film from the polymer easily.

### Background Art

Formation of a pattern on a silicon thin film (such as an amorphous silicon film or a polysilicon film) which is applied to an integrated circuit and a thin-film transistor is generally conducted by a method comprising, for example, forming a silicon film all over the film by a vacuum process such as a CVD (Chemical Vapor Deposition) process and then removing unnecessary portions by photolithography. However, this method has problems that a large-scale apparatus is required, that the use efficiency of raw material is low, that the raw material is difficult to handle because it is gas and that a large quantity of wastes are produced.

JP-A 1-29661 (the term "JP-A" as used herein means an "unexamined published Japanese patent application") discloses a method for forming a silicon-based thin film by liquefying and adsorbing a gaseous raw material on a cooled substrate and reacting the raw material with chemically active atomic hydrogen. However, the method not only has a problem that a complex apparatus is required since gasification and cooling of silicon hydride as a raw material are carried out successively but also has a problem that control of film thickness is difficult.

Further, JP-A 5-144741 and JP-A 7-267621 disclose a method for forming a silicon film by applying liquid silicon hydride to a substrate and exposing the coating film to heat or ultraviolet radiation. However, these methods have a problem in dealing with the system because it is unstable due to use of the low-molecular-weight material. Further, since the solution used in these methods has poor wettability to the substrate, it is difficult in the first place to apply it to the substrate. In addition, since it has a low molecular weight, it has a low boiling point, it evaporates faster than the silicon film is formed at the time of heating, so that it is very difficult to obtain the desired film. That is, it is an important point in formation of the film to use high-order silane which has a high molecular weight (i.e. which has good wettability and a high boiling point and is safe).

As a solution thereto, JP-A 10-321536 discloses a method comprising thermally decomposing or photo-decomposing a mixture of a solution of high-order silane before applying and a catalyst to improve the wettability of the solution. However, this method has a problem that it requires mixing of the catalyst such as nickel into the solution, thereby degrading the properties of silicon film significantly.

A method for directly synthesizing a silane compound having a high molecular weight has a problem that synthesis procedures and a purification process are generally very difficult. Although a method for directly synthesizing high-order silane by thermal polymerization has been attempted as described in JP-A 11-260729, the method merely gives Si₉H₂₀ in low yield, and this molecular size is still insufficient to develop the above properties such as wettability.

Meanwhile, to form a silicon film containing an n-type or p-type dopant, it is generally carried out to implant the dopant by an ion implantation method after forming the silicon film. Meanwhile, JP-A 2000-31066 describes a method for forming a doped silicon film by mixing a dopant source into a liquid material in the above process of formation of a silicon film comprising a high-order silane solution. However, even this method has a fundamental problem in using a low-molecular-weight material, i.e. a problem that the dopant source evaporates as the high-order silane solution evaporates and decreases during heating. Hence, the problem makes it difficult to add the dopant effectively.

### Disclosure of the Invention

An object of the present invention is to provide a silane polymer which is excellent from the viewpoint of wettability, a boiling point and safety when applied to a substrate and, particularly, has a specific high molecular weight that makes it possible to form a high-quality silicon film easily.

Another object of the present invention is to provide an industrially advantageous production method of the above silane polymer of the present invention.

Still another object of the present invention is to provide a silicon film forming composition containing the above silane polymer of the present invention.

Still another object of the present invention is to provide a method for forming an excellent silicon film by use of the above silicon film forming composition of the present invention.

Other objects and advantages of the present invention will become apparent from the following description.

According to the present invention, firstly, the above objects and advantages of the present invention are achieved by a silane polymer having a weight average molecular weight in terms of polystyrene measured by gel permeation chromatography of 800 to 5,000.

According to the present invention, secondly, the above objects and advantages of the present invention are achieved by a method for producing a silane polymer which comprises exposing a photopolymerizable silane compound to light of specific wavelength range to produce the silane polymer of the present invention.

According to the present invention, thirdly, the above objects and advantages of the present invention are achieved by a silicon film forming composition containing the silane polymer of the present invention and an organic solvent.

According to the present invention, fourthly, the above objects and advantages of the present invention are achieved by a method for forming a silicon film which comprises applying the silicon film forming composition of the present invention on a substrate and subjecting the coating film to at least one of a heat treatment and a light treatment.

### Brief Description of the Drawings

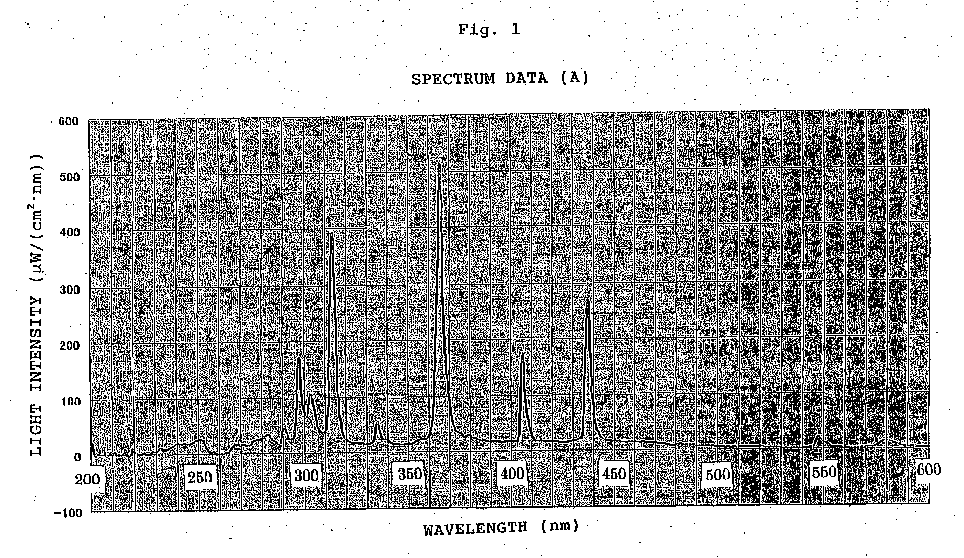

Fig. 1 is spectrum data when light was irradiated at all wavelengths.

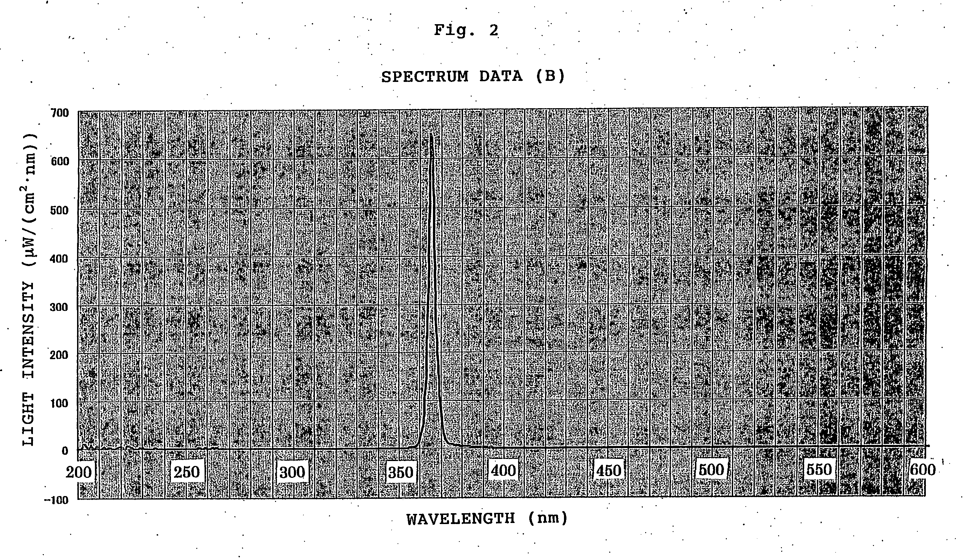

Fig. 2 is spectrum data when light having a wavelength of 365 nm was irradiated.

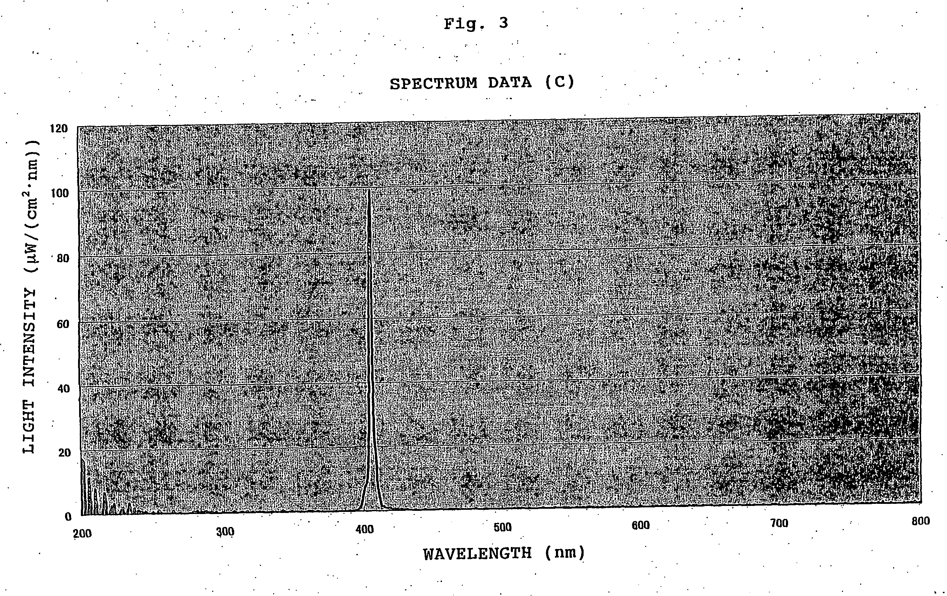

Fig. 3 is spectrum data when light having a wavelength of 405 nm was irradiated.

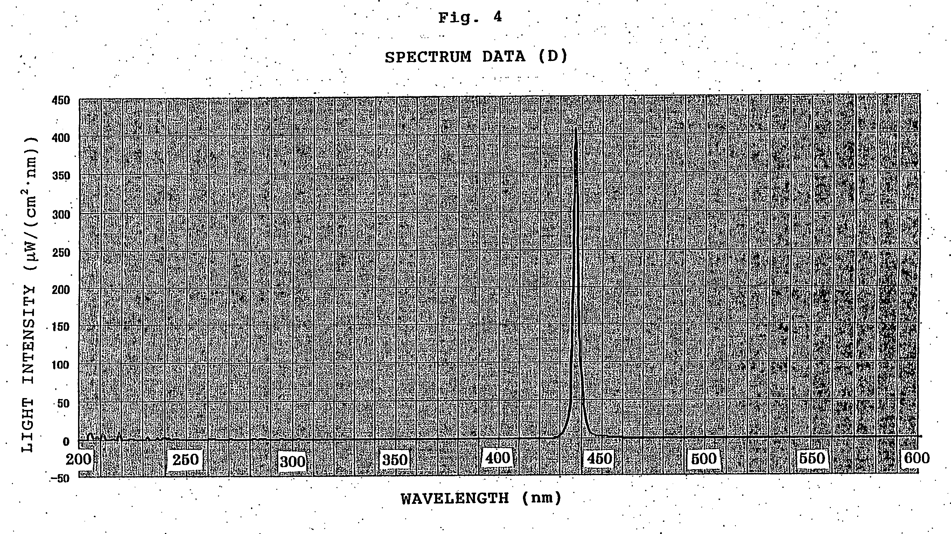

Fig. 4 is spectrum data when light having a wavelength of 436 nm was irradiated.

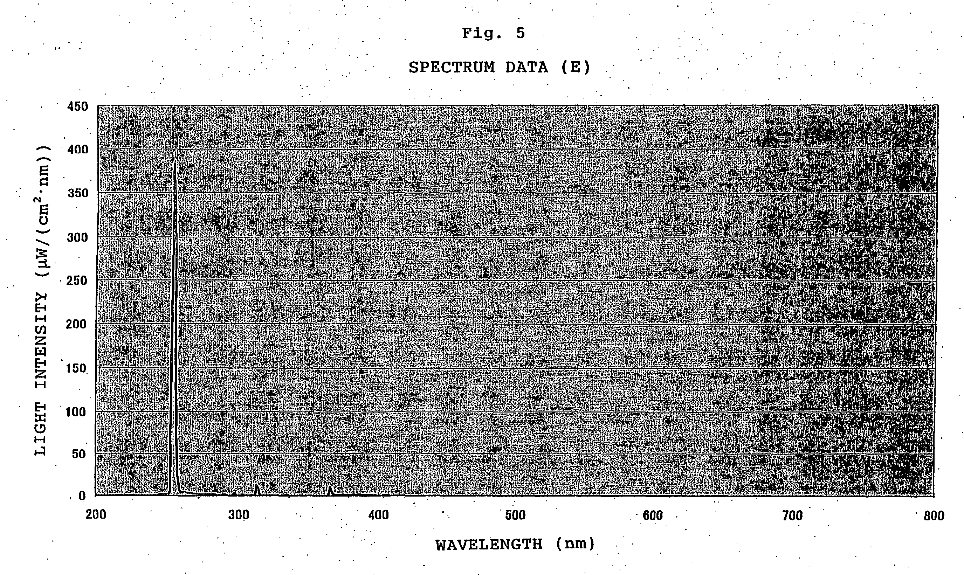

Fig. 5 is spectrum data when light having a wavelength of 254 nm was irradiated.
Fig. 6 is a GC spectrum diagram of sample No. 3 obtained in Example 1.
Fig. 7 is a GC spectrum diagram of sample No. 4 obtained in Example 1.
Fig. 8 is a GC spectrum diagram of sample No. 5 obtained in Example 1.
Fig. 9 is a GC spectrum diagram of sample No. 6 obtained in Example 1.
Fig. 10 is a GC spectrum diagram of sample No. 9 obtained in Example 1.
Fig. 11 is an MS spectrum diagram of the sample No. 3 obtained in Example 1.
Fig. 12 is a GPC chart of silane polymer obtained in Example 9.

### Best Mode for Carrying out the Invention

### (Silane Polymer)

The silane polymer of the present invention has a weight average molecular weight (Mw) in terms of polystyrene measured by gel permeation chromatography of 800 to 5,000, preferably 1,000 to 5,000, more preferably 1,200 to 5,000. When the Mw is lower than the lower limit, film formability is not satisfactory, while when it is higher than the upper limit, solubility in a solvent is apt to be insufficient. Further, the number average molecular weight (Mn) of the above silane polymer is preferably 600 to 2,000.

It has heretofore been difficult to measure the Mw of silane polymer by gel permeation chromatography (GPC). According to the present invention, it has been revealed that the Mw can be measured easily under the following conditions.

A special GPC instrument does not have to be used, and a commercial GPC instrument can be used. The concentration of oxygen in the measurement atmosphere upon measurement by the GPC instrument is preferably not higher than 100 ppm, more preferably not higher than 10 ppm. Such a measurement atmosphere can be prepared easily by, for example, placing the GPC instrument in a sealed environment such as a glove box. Illustrative examples of a column filler at the time of measurement include a polystyrene based filler, such as a styrene-divinyl benzene copolymer based filler, a polymethacrylate based polymer filler, a silica gel based filler, a dextran based filler and a porous glass based filler. Of these, the polystyrene based filler is preferred, and the styrene-divinyl benzene copolymer based filler is particularly preferred. Illustrative examples of a solvent to be used include toluene, o-xylene, m-xylene, p-xylene, cis-decalin, trans-decalin, benzene, cyclopentane, cyclohexane, n-pentane, n-hexane, n-heptane, n-octane, tetrahydrofuran, diethyl ether, and methylene chloride. Of these, toluene is particularly preferred. The solvent is preferably degassed upon use to a dissolved oxygen content of 10 ppm or lower, more preferably 0.5 ppm or lower. Further, it is recommended that the solvent be dried to a water content of preferably 300 ppm or lower, more preferably 30 ppm or lower.

The concentration of sample at the time of measurement is preferably 0.01 to 10 vol%, more preferably 0.1 to 5 vol%.

As a detector in the GPC instrument, any of a refractive index detector, a light scattering detector and a viscosity detector can be used, for example. Of these, the refractive index detector is desired.

A silane polymer in a waste solution from the GPC instrument can be deactivated by a method described in JP-A 2002-66866, for example.

The silane polymer of the present invention is obtained by exposing a photopolymerizable silane compound to light of specific wavelength range. Thus, the silane polymer of the present invention is formed by exposing a photopolymerizable silane compound to light of specific wavelength range to photopolymerize the silane compound.

The silane polymer of the present invention may be produced by exposing a solution of the photopolymerizable silane compound to light of specific wavelength range or exposing the silane compound in a liquid form to light of specific wavelength range to photopolymerize the silane compound.

As the light of specific wavelength range to which the silane compound is exposed, light having a wavelength of preferably 300 nm to 420 nm, particularly preferably 360 nm to 420 nm is used. When the wavelength is shorter than 300 nm, components insoluble in a solvent are liable to be produced, and film formation using it is liable to involve difficulty, while when the wavelength is longer than 420 nm, polymerization of the silane compound is liable to be slow.

Alternatively, a method comprising irradiating the silane compound with light having a wavelength of not longer than 420 nm and filtering the irradiated compound to separate solvent insoluble components which may be produced may be used. In this method, light having a wavelength of shorter than 300 nm which is out of the specific wavelength range can be used for the irradiation. In that case, the irradiation is preferably conducted in the absence of a solvent. If a solvent is present, the silicon polymer is liable to be contaminated by impurities. When light having a wavelength of not shorter than 300 nm which is within the specific wavelength range is to be irradiated, a solvent can be used, and the above problem does not occur easily even if the solvent is used. The filtration after the irradiation can be carried out by means of, for example, a filter having openings of 0.1 to 3.0 µm in diameter or by centrifugal separation.

Although the irradiation time is not limited by light intensity, irradiation conditions and the like, it is preferably 0.1 seconds to 600 minutes, particularly preferably 1 to 120 minutes to obtain a desired silane polymer. As for an irradiation method, light may be irradiated intermittently or with light intensity being gradually changed, in addition to a method of irradiating light continuously or discontinuously.

Further, to obtain the desired silane polymer, the irradiation is preferably carried out such that light is irradiated all over the silane compound or solution thereof uniformly while the silane compound or solution thereof is agitated.

Illustrative examples of the silane compound used to produce the silane polymer of the present invention include a chain silane compound represented by the formula:

SiᵢX₂ᵢ₊₂

(wherein X is a hydrogen atom or a halogen atom, and i is an integer of 2 to 10),
a cyclic silane compound represented by the formula:

SiⱼX₂ⱼ

(wherein X is a hydrogen atom or a halogen atom, and j is an integer of 3 to 10),
a cyclic silane compound represented by the formula:

SiₘX₂ₘ₋₂

(wherein X is a hydrogen atom or a halogen atom, and m is an integer of 4 to 10),
and a basket-shaped silane compound represented by the formula:

SiₖXₖ

(wherein X is a hydrogen atom or a halogen atom, and k is 6, 8 or 10). Of these, the cyclic silane compound represented by the formula SiⱼX₂ⱼ and the silane compound represented by the formula SiₘX₂ₘ₋₂ which has two or more cyclic structures are preferred.

Illustrative examples of a silane compound having a cyclic structure include cyclotrisilane, cyclotetrasilane, cyclopentasilane, cyclohexasilane, and cycloheptasilane. Illustrative examples of a silane compound having two cyclic structures include 1,1'-bicyclobutasilane, 1,1.'-bicyclopentasilane, 1,1'-bicyclohexasilane, 1,1'-bicycloheptasilane, 1,1'-cyclobutasilylcyclopentasilane, 1,1'-cyclobutasilylcyclohexasilane, 1,1'-cyclobutasilylcycloheptasilane, 1,1'-cyclopentasilylcyclohexasilane, 1,1'-cyclopentasilylcycloheptasilane, 1,1'-cyclohexasilylcycloheptasilane, spiro[2.2]pentasilane, spiro[3.3]heptasilane, spiro[4.4]nonasilane, spiro[4.5]decasilane, spiro[4.6]undecasilane, spiro[5.5]undecasilane, spiro[5.6]undecasilane, and spiro[6.6]tridecasilane. Illustrative examples thereof further include silane compounds resulting from substituting some of the hydrogen atoms in the skeletons of the above silane compounds with an SiH₃ group or a halogen atom such as a fluorine atom, chlorine atom, bromine atom or iodine atom. These may be used in admixture of two or more.

Of these, silane compounds having at least one cyclic structure in the molecule are preferably used since they have extremely high reactivity with light and photopolymerization can be carried out efficiently. Of these, a silane compound represented by the formula SiₙX₂ₙ (wherein n and X are the same as defined in the above formulae) and having one cyclic structure in the molecule such as cyclotetrasilane, cyclopentasilane, cyclohexasilane or cycloheptasilane is particularly preferred because of ease of its synthesis and purification, in addition to the above reason.

As the silane compound, the above silane compounds having cyclic structures are preferred. However, as long as the photopolymerization process by irradiation of light in the present invention is not inhibited, silane compounds modified with a boron atom and/or a phosphorous atom can be used in combination with the above cyclic silane compounds.

Further, when photopolymerization of the silane compound is conducted in a solution, a solvent for preparing a solution of the silane compound is not particularly limited as long as it can dissolve the silane compound and does not react with the compound. A solvent showing a vapor pressure at room temperature of 0.001 to 200 mmHg is preferably used. When the vapor pressure is higher than 200 mmHg, the solvent evaporates first when a coating film is formed by coating, making it difficult to form a good coating film. On the other hand, when the vapor pressure is lower than 0.001 mmHg, a coating film formed by coating is dried so slowly that the solvent is liable to remain in the coating film of the silane compound, making it difficult to obtain a high-quality silicon film after a subsequent heat and/or light treatment step.

Further, as the above solvent, a solvent whose boiling point at normal pressure is equal to or higher than room temperature and lower than 250 to 300°C which is the decomposition point of the silane polymer is preferably used. By use of the solvent whose boiling point at normal pressure is lower than the decomposition point of the silane polymer, only the solvent can be selectively removed by heating without decomposing the silane polymer after coating. Thereby, it can be prevented that the solvent remains in the silicon film, and a higher quality film can be obtained.

Specific examples of the solvent used in the solution of the silane compound include hydrocarbon-based solvents such as n-hexane, n-heptane, n-octane, n-decane, dicyclopentane, benzene, toluene, xylene, durene, indene, tetrahydronaphthalene, decahydronaphthalene and squalane; ether-based solvents such as dipropyl ether, ethylene glycol dimethyl ether, ethylene glycol diethyl ether, ethylene glycol methylethyl ether, diethylene glycol dimethyl ether, diethylene glycol diethyl ether, diethylene glycol methylethyl ether, tetrahydrofuran, tetrahydropyran, 1,2-dimethoxyethane, bis(2-methoxyethyl)ether and p-dioxane; and polar solvents such as propylene carbonate, γ-butyrolactone, N-methyl-2-pyrrolidone, dimethyl formamide, acetonitrile and dimethyl sulfoxide. Of these, the hydrocarbon-based solvent and the ether-based solvent are preferred from the viewpoints of the dissolubility of the silane compound and the stability of the solution, and the hydrocarbon-based solvent is particularly preferred. These solvents can be used alone or in admixture of two or more.

According to the silane polymer of the present invention, a high-quality silicon film can be formed easily as compared with the conventional methods due to the above effects. The thus formed amorphous silicon film can be crystallized by a further heat treatment or a method such as eximer laser annealing to further improve its performance.

The silane polymer used in the method of the present invention is obtained by irradiating a photopolymerizable silane compound with light to photopolymerize the compound as described above. At that time, the photopolymerization can be conducted in the presence of a material (dopant source) containing an element of the 3B group in the periodic table or a material (dopant source) containing an element of the 5B group in the periodic table, together with the above silane compound.

Thus, when the silicon film is formed, a process comprising mixing the dopant source into the above silane compound and irradiating the mixture with light is a novel process which is not found in the conventional methods. According to the process, bonding between the dopant and the silane polymer can be induced on the molecular level by irradiation of light, and an n-type or p-type doped silicon film with a good performance can be formed by applying the solution to a substrate and subjecting the applied solution to a heat treatment and/or a light treatment. Further, a doped silicon film formed by the process can have its properties further improved by a step such as heating. In particular, when a silane polymer formed from a solution of a silane compound containing this material is applied to a substrate and then subjected to a heat treatment and/or a light treatment which will be described later, the material (dopant) can be activated.

Further, the concentration of the dopant source to be added is determined according to the concentration of dopant which is eventually needed in the silicon film. The concentration may be adjusted by diluting it with a solvent after irradiation of light, or the dopant source may be mixed with a silane polymer irradiated with light without addition of the dopant source.

As the material (dopant) containing an element of the 3B group and the material (dopant) containing an element of the 5B group in the periodic table, materials containing elements such as phosphorous, boron and arsenic are preferred. More specifically, materials such as those described in JP-A 2000-31066 can be named as examples.

The silicon film forming composition of the present invention comprises the above silane polymer and an organic solvent. The concentration of the silane polymer in the silicon film forming composition of the present invention is preferably about 1 to 80 wt% so as to prevent non-uniform deposition of the silane polymer when the composition is applied to a substrate to form the silicon film and to obtain a uniform coating film. The concentration of the silane polymer in the present composition can be adjusted as appropriate according to a desired silicon film thickness. The lower limit is more preferably 2 wt%, much more preferably 5 wt%, particularly preferably 10 wt%.

Illustrative examples of organic solvents which can be contained in the silicon film forming composition of the present invention include the organic solvents described above as solvents which can be used when photopolymerization of the silane compound is carried out in a solution.

The silicon film forming composition of the present invention can further contain other additives as required.

To the silicon film forming composition of the present invention, a material containing an element of the 3B group in the periodic table or a material containing an element of the 5B group in the periodic table can be further added as a dopant source. A desired n-type or p-type doped silicon film can be formed by appropriately selecting and adding such a material. In a process of forming a silicon film by use of a composition containing such a material, the composition does not evaporate easily due to the high boiling point of the silane polymer and evaporation of the dopant source can also be suppressed accordingly, so that a dopant can be introduced into the film more efficiently than the conventional methods. Further, as described above, when the silane polymer has been formed by adding the material to the above solution of the silane polymer at the time of photopolymerization, there is no need to add the material at this stage (i.e. after completion of the photopolymerization). Illustrative examples of the material containing an element of the 3B group in the periodic table and the material containing an element of the 5B group in the periodic table include those presented as these materials which are added to the above silane compound before irradiation of ultraviolet radiation. Further, after this silicon film forming composition is applied to a substrate, the material (dopant) can be activated by the heat treatment and/or light treatment which will be described later.

Further, to the silicon film forming composition of the present invention, a fluorine-based, silicone-based or nonionic surface tension regulator can be added as required in such a trace amount that does not impair the desired function of the composition. These surface tension regulators improve the wettability of the solution with respect to an object to be coated, improve the leveling property of the coating film and are useful for preventing the occurrences of small bumps and orange peel in the coating film.

The silane polymer of the present invention is particularly useful for formation of a silicon film which is applied to applications such as an integrated circuit, a thin-film transistor, a photoelectric converter and a photoreceptor.

### (Method for Forming Silicon Film)

Next, the method for forming a silicon film according to the present invention will be described in detail.

The method for forming a silicon film according to the present invention comprises applying the above silicon film forming composition to a substrate and subjecting the coated substrate to a heat treatment and/or a light treatment. Otherwise, the same technique as that of a method for forming a silicon film by use of a commonly used solution. Further, after a composition containing a solvent is applied to a substrate as the above composition, a step of selectively removing only the solvent may be carried out before the step of conducting the above heat treatment and/or light treatment.

Unlike a process which supplies gas such as a commonly practiced CVD process, the method for forming a silicon film according to the present invention comprises applying the above composition to a substrate, drying a solvent as required to form a silane polymer film, converting this film into a silicon film by thermal decomposition and/or photodecomposition, and further converting the silicon film into a polycrystalline silicon film by a laser treatment as required. The method further comprises forming a p-type or n-type silicon film without subjecting a silicon film modified with a boron atom or a phosphorous atom to ion implantation in a vacuum system.

As a method of applying the composition, a method such as a spin coating method, roll coating method, curtain coating method, dip coating method, spray coating method or droplet discharging method can be used. The application is generally carried out at temperatures higher than or equal to room temperature. At temperatures lower than room temperature, the dissolubility of the silane polymer lowers, so that the silane polymer may be partially deposited. The silane compound, silane polymer and silicon film forming composition in the present invention are liable to be modified by reacting with water and oxygen. Therefore, a series of steps are preferably carried out in the absence of water and oxygen. Thus, the atmosphere in the steps preferably comprises an inert gas such as nitrogen, helium or argon. The atmosphere preferably further comprises a reducing gas such as hydrogen as required. Further, solvents and additives free of water and oxygen are desirably used.

The droplet discharging method is a method of forming a desired pattern comprising a discharged material by discharging droplets in a desired area and is also referred to as "ink-jet method". In this case, droplets to be discharged are not so-called ink used in prints but a liquid material including a material which constitutes a device, and this material includes a material which can serve as a conductive material or insulation material constituting a device, for example. Further, droplet discharging is not limited to spraying droplets at the time of discharging and also includes a case where individual droplets of liquid material are discharged continuously.

Further, the spin speed of a spinner when the spin coating method is employed is determined by the thickness of thin film to be formed and the composition of the coating solution and is preferably 100 to 5,000 rpm, more preferably 300 to 3,000 rpm.

In the method of the present invention for forming a silicon film, a heat treatment may be carried out to remove low-boiling-point components such as a solvent after the silicon film forming composition is applied. The heating temperature varies according to the kind and boiling point (vapor pressure) of solvent to be used and is 100 to 200°C, for example. The heat treatment is preferably carried out in the same atmosphere as that in the above application step, i.e., in an inert gas such as nitrogen, helium and argon. At that time, removal of the solvent can be carried out at lower temperatures by reducing the pressure of the whole system. Thereby, thermal degradation of the substrate can be reduced.

Further, in the method for forming a silicon film according to the present invention, the silane polymer on the substrate from which the solvent has been removed is converted into a silicon film by a heat treatment and/or a light treatment, and the silicon film obtained by the film formation method of the present invention is amorphous or polycrystalline. In general, in the heat treatment, an amorphous silicon film is obtained at a reached temperature of about 550°C or lower, and a polycrystalline silicon film is obtained at temperatures higher than the temperature. When the amorphous silicon film is desired, preferably 300°C to 550°C, more preferably 350°C to 500°C, are used. When the reached temperature is lower than 300°C, a silicon film having a satisfactory thickness may not be formed.

In the present invention, the heat treatment is preferably carried out in an atmosphere comprising an inert gas such as nitrogen, helium or argon or a reducing gas such as hydrogen. When the polycrystalline silicon film is desired, it can be obtained by irradiating the amorphous silicon film obtained above with a laser beam.

Meanwhile, as a source of light used when the light treatment is carried out, a low-pressure or high-pressure mercury lamp, a deuterium lamp, a discharge spark of noble gas such as argon, krypton or xenon, a YAG laser, an argon laser, a carbon dioxide gas laser, and an eximer laser such as XeF, XeCl, XeBr, KrF, KrCl, ArF or ArCl can be used. As these light sources, those with an output of 10 to 5,000 W are preferably used, but those with an output of 100 to 1,000 W are generally sufficient. The wavelength of these light sources is not particularly limited as long as it is absorbed by the silane polymer. It is preferably 170 to 600 nm. Further, use of a laser beam is particularly preferred from the viewpoint of the efficiency of conversion into the polycrystalline silicon film. The temperature at which the light treatment is carried out is preferably room temperature to 1, 500°C and can be selected as appropriate according to the semiconducting properties of the silicon film to be obtained.

The substrate used in the method for forming a silicon film according to the present invention is not particularly limited. For example, in addition to commonly used quartz, borosilicate glass and soda glass, there can be used a transparent electrode such as ITO, a metal substrate such as gold, silver, copper, nickel, titanium, aluminum or tungsten, and glass and plastic substrates having these metals or oxides of these metals on the surfaces thereof.

The silicon film obtained by the method for forming a silicon film according to the present invention can be applied to applications such as an integrated circuit, a thin-film transistor, a photoelectric converter and a photoreceptor.

Hereinafter, the present invention will be further described with reference to Examples.

### Example

Bandpass filters used in Examples are as follows.
Bandpass Filter for 365 nm: Model Number "MX0365" of Asahi Spectra Co., Ltd.
Bandpass Filter for 405 nm: Model Number "MX0405" of Asahi Spectra Co., Ltd.
Bandpass Filter for 436 nm: Model Number "MX0436" of Asahi Spectra Co., Ltd.

Further, an instrument used to measure light intensity in Examples is a spectral radiant light intensity meter "spectroradiometer USR-40D" (product of USHIO INC.).

### Synthesis Example 1

After the inside of a 3-liter four-neck flask equipped with a thermometer, a condenser, a dropping funnel and an agitator was substituted with an argon gas, 1 liter of dried tetrahydrofuran and 18.3 g of lithium metal were added, and the contents of the flask were bubbled with an argon gas. While this suspension was agitated at 0°C, 333 g of diphenyl dichlorosilane was added through the dropping funnel. After completion of the dropping, the mixture was further agitated at room temperature for 12 hours until the lithium metal disappeared completely. The reaction mixture was poured into 5 liters of ice water to precipitate the reaction product. After the precipitate was separated by filtration and cleaned well with water, it was cleaned with cyclohexane, vacuum-dried and recrystallized with ethyl acetate to obtain 150 g of white solid.

150 g of the obtained white solid and 500 ml of dried cyclohexane were charged into a 1-liter flask, 20 g of aluminum chloride was added, and with the reaction temperature kept at 30°C, the resulting mixture was bubbled with a dried hydrochloric gas under agitation for 10 hours. Then, 50 g of aluminum lithium hydride and 150 ml of diethyl ether were charged into another 1-liter flask, the above reaction mixture was added under agitation at 0°C in a nitrogen atmosphere, and the resulting mixture was agitated at 0°C for 1 hour and then at room temperature for 12 hours. The reaction solution was suction-filtrated, a by-product was removed from the filtrate, and vacuum distillation was carried out at 70°C and 10 mmHg. As a result, 10 g of colorless liquid was obtained. This was determined to be cyclopentasilane from IR, ¹H-NMR, ²⁹Si-NMR and GC-MS spectra.

### Example 1

In a nitrogen gas stream (oxygen concentration: 3 ppm or lower) , 1 ml of cyclopentasilane was charged into a sample tube made of quartz, agitated, and exposed to lights emitted from a 200-W mercury xenon lamp (EXECURE 3000 of HOYA Candeo Optronics Co., Ltd.) and an ultraviolet lamp (EF-140C/J of Spectronics Co., Ltd.). Light having a wavelength of 254 nm was irradiated at 0 cm from the light source and with a lamp output of 100%, and lights having other wavelengths were irradiated at a distance of 1 cm from the light source and with a lamp output of 20%. The experiment was carried out by adjusting the light exposure by use of a light intensity adjusting device provided in the apparatus and by extracting light of each wavelength by use of bandpass filters.

Light intensities at the wavelengths of lights used in this experiment are shown in the following Table 1. The light intensity is a value converted from a spectrum measured by use of "spectroradiometer USR-40D" (product of USHIO INC.) at a distance of 1 cm from a fiber from which the light was emitted.

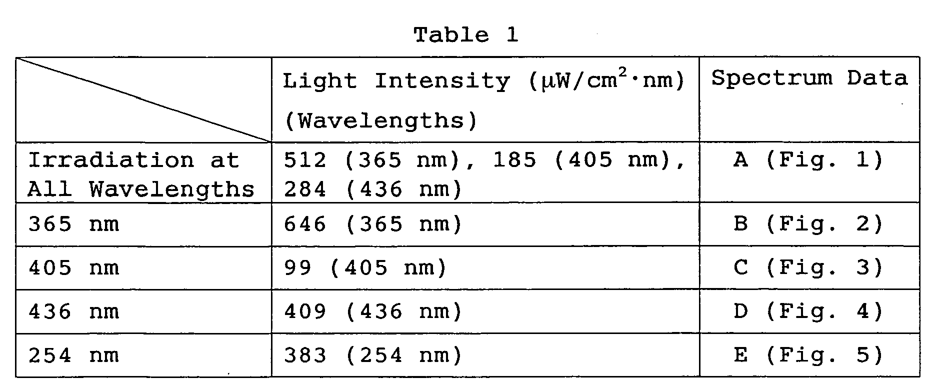

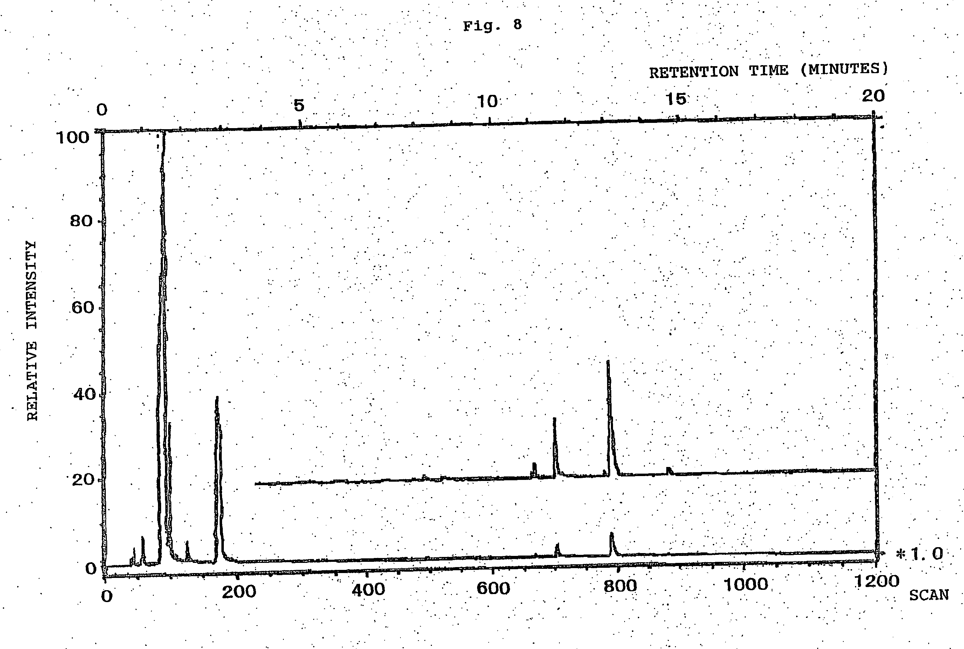

Silicon polymers were obtained by use of the lights of the above wavelengths by changing the time to irradiate the sample, and 9 ml of toluene was added to prepare 10% (V/V) solutions. The features of the 10% solutions and the results of observing the appearances of films after the solutions were spin-coated on quartz substrates at 1,500 rpm and then heat-treated at 400°C for 30 minutes are shown in Table 2. As a result of making an ESCA analysis on the heat-treated film (Fig. 8) formed from the sample (No. 5) , this film was found to be a silicon film because a chemical shift derived from silicon was observed at 99.0 eV.

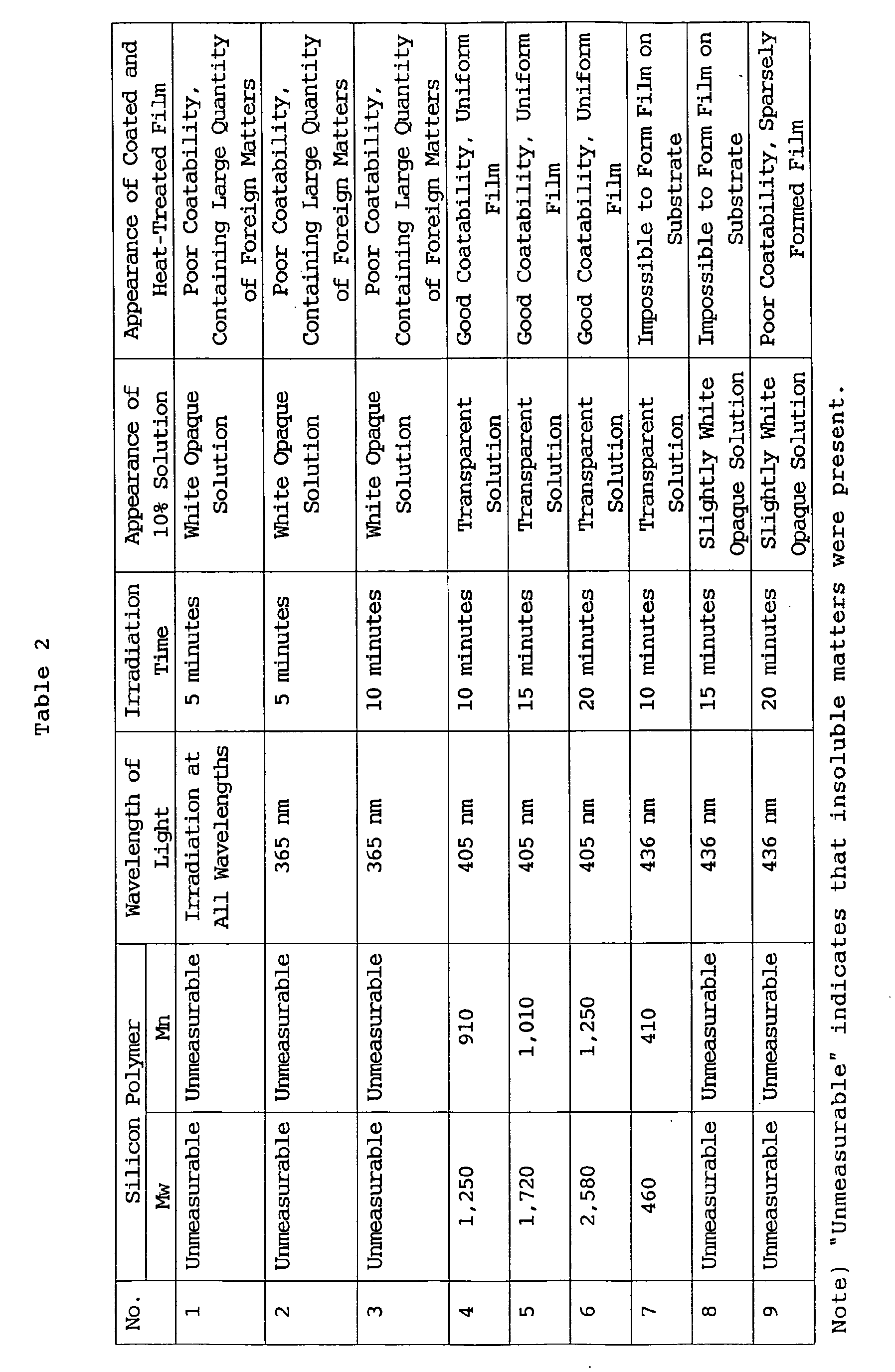

As shown by the above results, it was found that when cyclopentasilane was selectively irradiated with light having a wavelength of 405 nm as a main constituent, transparent, uniform solutions could be prepared, and the qualities of silicon films obtained by coating and heat-treating the solutions were good.

Measurement conditions for GPC are as follows.

### Measuring Instruments:

GPCMAX and TDA-302 of VISCOTEK CO., Ltd. were placed in a glove box as gel permeation chromatographic analyzers, and GPC was carried out in a nitrogen gas stream at an oxygen concentration of not higher than 10 ppm.

As columns for gel permeation chromatographic analysis, TSK-GELG3000HHR, TSK-GELG2000HHR and TSK-GELG1000HHR (all of these three columns contained a styrene-divinylbenzene copolymer having a particle diameter of 5 µm) of Tosoh Corporation which were tandemly arranged were used.

TDA-302 was used as a detector, and a refractive index detector having a cell capacity of 12 µL and a light-emitting diode of 660 nm as a light source was used as a detector.

### Solvent:

The analysis was conducted by using dehydrated toluene (water content: 30 ppm or lower) for synthesis of Wako Pure Chemical Industries, Ltd. as a measuring solvent. The deoxidization of the solvent was carried out by a 2-channel degasser provided in GPCMAX.

### Sample:

A silane polymer as a sample was formed into a 20-vol% toluene solution. 100 µl of this solution was sampled, and 1,900 µl of toluene was added to adjust the concentration of the silane polymer to 1 vol%. Then, the mixture was filtered through a polytetrafluoroethylene membrane filter having openings of 0.45 µm to prepare a GPC measurement sample.

### Injection Conditions:

The sample was measured at an injection volume of 100 µl, a column temperature of 30°C and a toluene flow rate of 0.8 ml/min.

### Disposal of GPC Waste Solution

After completion of the measurement, a GPC waste solution containing the silane polymer was disposed by adding 1 part of 2-methyl-2-pentanol dimethyl dodecyl amine/propylene glycol monomethyl ether mixed solution (volume ratio: 50/50) per 10 parts of the waste solution in a glove box having an oxygen concentration of 10 ppm or lower, agitating the solution for two weeks to deactivate it, and then burning it.

### Example 2

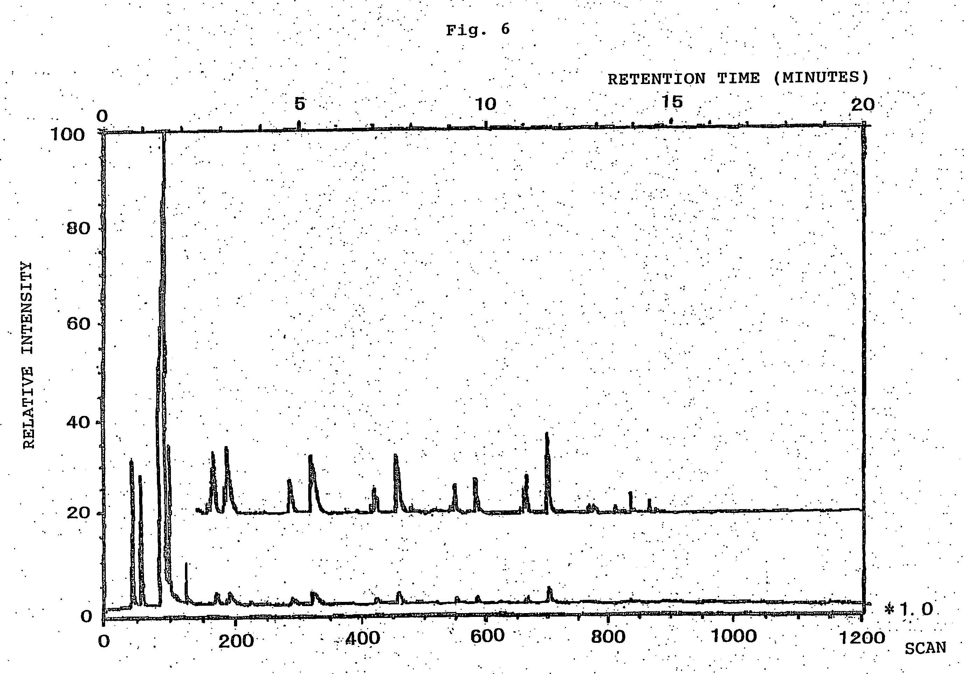

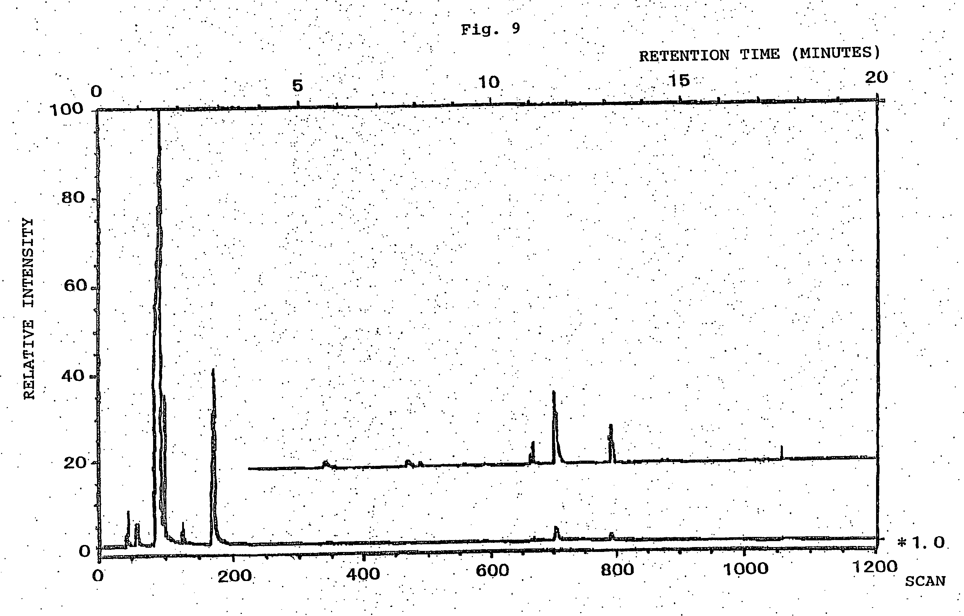

The above prepared samples Nos. 3, 4, 5, 6 and 9 were GC(-MS) analyzed for components dissolved in toluene by use of GC. The GC column used in the measurement was BPX-5. The injection temperature used in the measurement was 200°C. The column was heated to 200°C at 10°C/min from an initial temperature of 50°C and then kept at 200°C for 5 minutes. Photographs showing peaks at 5-fold magnification are shown in the middles of the charts in Figs. 6 to 10.

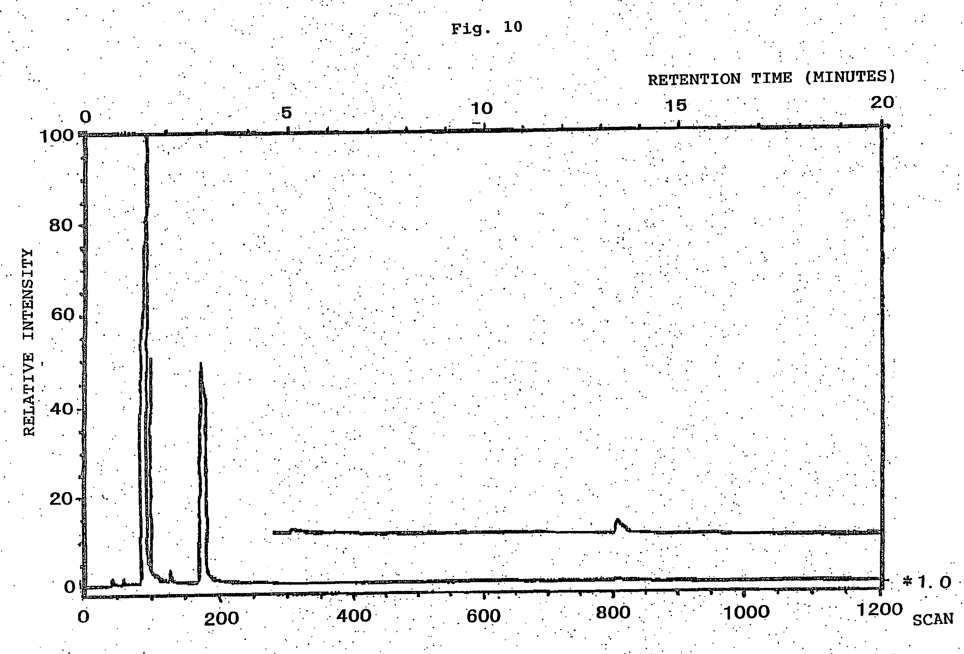

Referring to Fig. 6, it is seen that components were produced complicatedly in the sample solution exposed to a wavelength of 365 nm for 10 minutes. Referring to Fig. 10, it is seen that components other than cyclopentasilane (Si₅H₁₀) and toluene which were raw materials were produced in very small amounts in the sample exposed to a wavelength of 436 nm for 20 minutes.

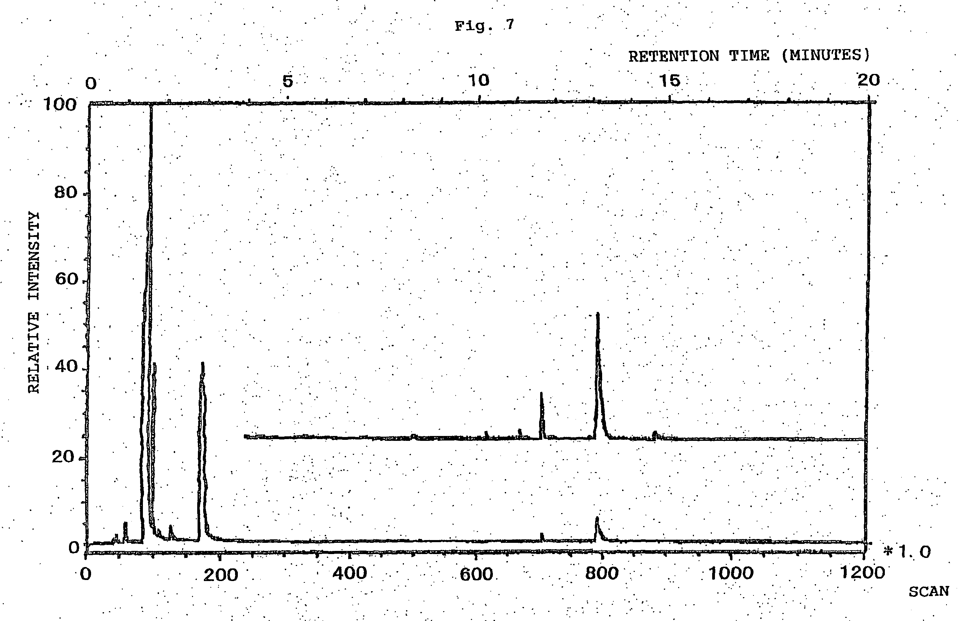

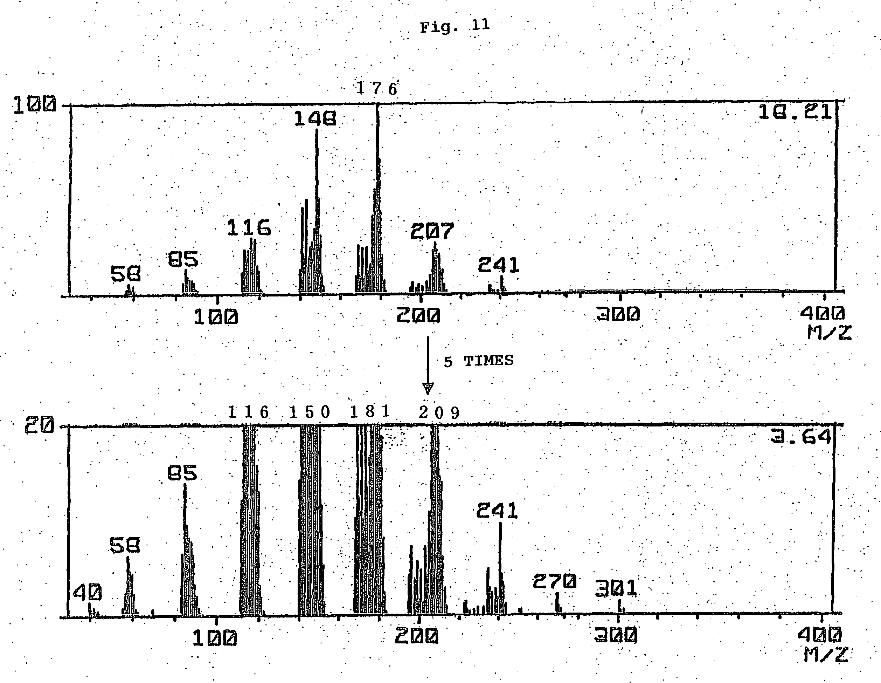

Meanwhile, referring to Figs. 7, 8 and 9, several components (three components) could be identified in the samples exposed to 405 nm for 10 to 20 minutes as components other than cyclopentasilane and toluene, and the 702 Scan component was identified as an Si₁₀H₂₂ component. Although the structures of the other two components by GC-MS are unknown, they are considered to be effective components as components which exert the performance in the present invention. Fig. 11 shows the MS spectrum of the 702 Scan component of the sample No. 5. In Fig. 11, the peak of M/ Z = 301 was estimated to be Si₁₀H₂₁⁺¹.

### Example 3

In a nitrogen gas stream (oxygen concentration: 3 ppm or lower), 1 ml of cyclopentasilane and 10 mg of decaborane were charged into a sample tube made of quartz, agitated, and irradiated with light having a wavelength of 405 nm (light described in Example 1) emitted from a 200-W mercury xenon lamp at a distance of 10 mm from the reaction solution for 20 minutes to give a silane polymer (Mw = 2,600, Mn = 1,200). Then, after 9 ml of toluene was added to prepare a toluene 10% solution, the solution was spin-coated on a quartz substrate at 1,500 rpm and heat-treated at 400°C for 30 minutes. When the sheet resistance of this sample was measured after the sample was further heat-treated at 800°C for 5 minutes, it was 700 kΩ/cm². When the sheet resistance of the same sample heat-treated at 400°C was measured after the sample was heat-treated at 900°C for 5 minutes, it was 0.5 kΩ/cm².

### Example 4

In a nitrogen gas stream (oxygen concentration: 3 ppm or lower), 1 ml of cyclopentasilane and 10 mg of yellow phosphorus were charged into a sample tube made of quartz, agitated, and irradiated with light having a wavelength of 405 nm (light described in Example 1) emitted from a 200-W mercury xenon lamp at a distance of 10 mm from the reaction solution for 20 minutes to give a silane polymer (Mw = 2,250, Mn = 1,220). Then, after 9 ml of toluene was added to prepare a toluene 10% solution, the solution was spin-coated on a quartz substrate at 1,500 rpm and heat-treated at 400°C for 30 minutes. When the sheet resistance of this sample was measured after the sample was further heat-treated at 800°C for 5 minutes, it was 50 kΩ/cm². When the sheet resistance of the same sample heat-treated at 400°C was measured after the sample was heat-treated at 900°C for 5 minutes, it was 10 kΩ/cm².

### Example 5

The polymer sample of the experiment No. 2 of Example 1 was filtered by a polytetrafluoroethylene membrane filter having openings of 0.45 µm to remove insoluble matters. When the silane polymer contained in the filtered solution was measured by gel permeation chromatography, it was found that Mn = 1,260 and Mw = 2,810.

When the above filtered solution was spin-coated on a quartz substrate in the same manner as in Example 1, its coatability was good. The obtained coating film was heat-treated at 400°C for 30 minutes. When the heat-treated film was analyzed by ESCA, a chemical shift derived from silicon was observed at 99.0 eV. Thus, this film was found to be a silicon film.

In the following Examples 6 to 9, measurements of the contents of remaining monomers by gas chromatography were carried out in the following manner.

As a sample, a solution comprising a silane compound, trans-decalin and toluene in a volume ratio of 10:10:90 was prepared by adding toluene to the exposed silane compound to prepare 200 µl of 10-vol% toluene solution and adding 20 µl of trans-decalin to this solution as an internal reference material. In a glove box having a nitrogen atmosphere (oxygen concentration: 0.5 ppm or lower), 1 µl of this solution was sampled by use of a microsyringe and subjected to a gas chromatographic analysis.

As a gas chromatographic analyzer, GC-14B of Shimadzu Corporation was used. TCD (Thermal Conductivity Detector) was used as a detector, S.OV-17 10% CV 60-80 AW-DMCS was used as a column for analysis, and helium was used as a carrier gas.

Analysis conditions are as follows. The injection temperature was 150°C, the temperature of the detector was 200°C, and the temperature of the column was changed such that after the column was kept at 70°C for 5 minutes, it was heated to 100°C at a temperature increasing rate of 10°C/min, then kept at 100°C for 15 minutes, then heated to 200°C at a temperature increasing rate of 10°C/min, and then kept at 200°C for 10 minutes.

The quantity of the cyclopentasilane solution contained in the sample solution was determined from the result of the analysis and the analytical curve which was prepared by using trans-decalin as a reference material, and the quantity of the monomer remaining in the exposed silane compound was calculated.

### Example 6

1 ml of the cyclopentasilane synthesized in Synthesis Example 1 was placed in a quartz vessel, the above bandpass filter for 365 nm was attached to a mercury xenon lamp Execure 3000 of HOYA Candeo Optronics Co. , Ltd. (so that light having spectral distribution corresponding to spectrum data B was obtained), and the sample was irradiated with light with an output of 20% for 2.5 minutes with the lamp in contact with the quartz vessel. When the irradiated silane polymer was measured by gel permeation chromatography, the silane polymer had Mn = 1,350 and Mw = 3,320. Further, when the amount of remaining cyclopentasilane was measured by gas chromatography, it was found that 25.5 wt% of cyclopentasilane remained unpolymerized.

Toluene was added to the silane compound containing the irradiated silane polymer to prepare a 20-wt% solution. After the solution was filtered by use of a polytetrafluoroethylene membrane filter having openings of 0.45 µm in diameter, it was spin-coated on a quartz substrate at 2,000 rpm. Its film formability was good.

When the obtained coating film was heat-treated at 400°C for 30 minutes, a film having a film thickness of 95 nm was obtained. When the heat-treated film was analyzed by ESCA, a chemical shift derived from silicon was observed at 99.0 eV. Thus, this film was found to be a silicon film.

Further, when the amounts of carbon and oxygen in the heat-treated film were measured by SIMS analysis, they were 9 × 10¹⁸ atoms/cm³ and 5 x 10¹⁹ atoms/cm³, respectively.

### Example 7

When 1 ml of the cyclopentasilane synthesized in Synthesis Example 1 was placed in a quartz vessel and irradiated with light with an output of 100% for 10 minutes at a distance of 0.5 cm from the quartz vessel by use of ultraviolet lamp EF-140C/J (which emitted light having spectral distribution corresponding to spectrum data E) for thin-layer chromatography of Spectronics Co. , Ltd. as a light source, a white suspension was obtained. When this suspension was measured by gel permeation chromatography after filtered by a polytetrafluoroethylene membrane filter having openings of 0.45 µm in diameter, the silane compound had Mn = 1,200 and Mw = 2,460. Further, when the amount of remaining cyclopentasilane was measured by gas chromatography, it was found that 36.9 wt% of cyclopentasilane remained unpolymerized.

Toluene was added to the filtered silane compound to prepare a 20-wt% solution. After the solution was filtered by use of a polytetrafluoroethylene membrane filter having openings of 0.45 µm in diameter, it was spin-coated on a quartz substrate at 2,000 rpm. Its film formability was good.

When the obtained coating film was heat-treated at 400°C for 30 minutes, a film having a film thickness of 103 nm was obtained. When the heat-treated film was analyzed by ESCA, a chemical shift derived from silicon was observed at 99.0 eV. Thus, this film was found to be a silicon film.

Further, when the amounts of carbon and oxygen in the heat-treated film were measured by SIMS analysis, they were 1 × 10¹⁹ atoms/cm³ and 7 x 10¹⁹ atoms/cm³, respectively.

### Example 8

When a silane compound was irradiated with light in the same manner as in Example 7 except that 0.2 ml of the cyclopentasilane synthesized in Synthesis Example 1 and 0.8 ml of toluene were used as raw materials, a colorless uniform solution was obtained. When the irradiated solution was measured by gel permeation chromatography, it had Mn = 1,020 and Mw = 2,100. Further, when the amount of remaining cyclopentasilane was measured by gas chromatography, it was found that 20.2 wt% of cyclopentasilane remained unpolymerized.

After the filtered silane compound was filtered by use of a polytetrafluoroethylene membrane filter having openings of 0.45 µm in diameter, it was spin-coated on a quartz substrate at 2,000 rpm. Its film formability was good.

When the obtained coating film was heat-treated at 400°C for 30 minutes, a film having a film thickness of 92 nm was obtained. When the heat-treated film was analyzed by ESCA, a chemical shift derived from silicon was observed at 99.0 eV. Thus, this film was found to be a silicon film.

Further, when the amounts of carbon and oxygen in the heat-treated film were measured by SIMS analysis, they were 1 × 10²¹ atoms/cm³ and 1 × 10²¹ atoms/cm³, respectively.

### Example 9

A silane compound was irradiated with light in the same manner as in Example 6 except that a bandpass filter for 405 nm was used and the irradiation time was 10 minutes. The irradiated light was light having spectral distribution corresponding to spectrum data C.

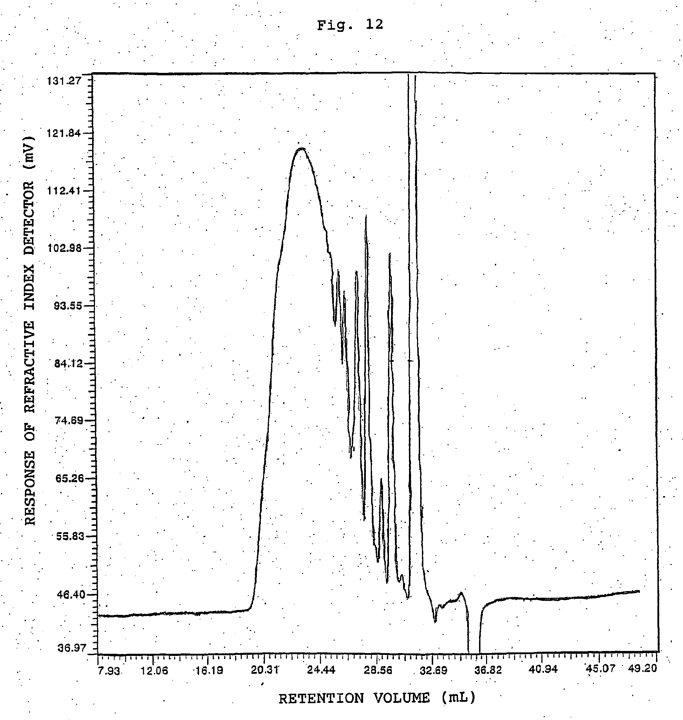

When the irradiated silane compound was measured by gel permeation chromatography, it had Mn = 1,060 and Mw = 1,950. The obtained gel permeation chromatogram is shown in Fig. 12. Further, when the amount of remaining cyclopentasilane was measured by gas chromatography, it was found that 29.9 wt% of cyclopentasilane remained unpolymerized.

Toluene was added to the silane compound containing the irradiated silane polymer to prepare a 20-wt% solution. After the solution was filtered by use of a polytetrafluoroethylene membrane filter having openings of 0.45 µm in diameter, it was spin-coated on a quartz substrate at 2,000 rpm. Its film formability was good.

When the obtained coating film was heat-treated at 400°C for 30 minutes, a film having a film thickness of 91 nm was obtained. When the heat-treated film was analyzed by ESCA, a chemical shift derived from silicon was observed at 99.0 eV. Thus, this film was found to be a silicon film.

Further, when the amounts of carbon and oxygen in the heat-treated film were measured by SIMS analysis, they were 1 × 10¹⁹ atoms/cm³ and 5 x 10¹⁹ atoms/cm³, respectively.

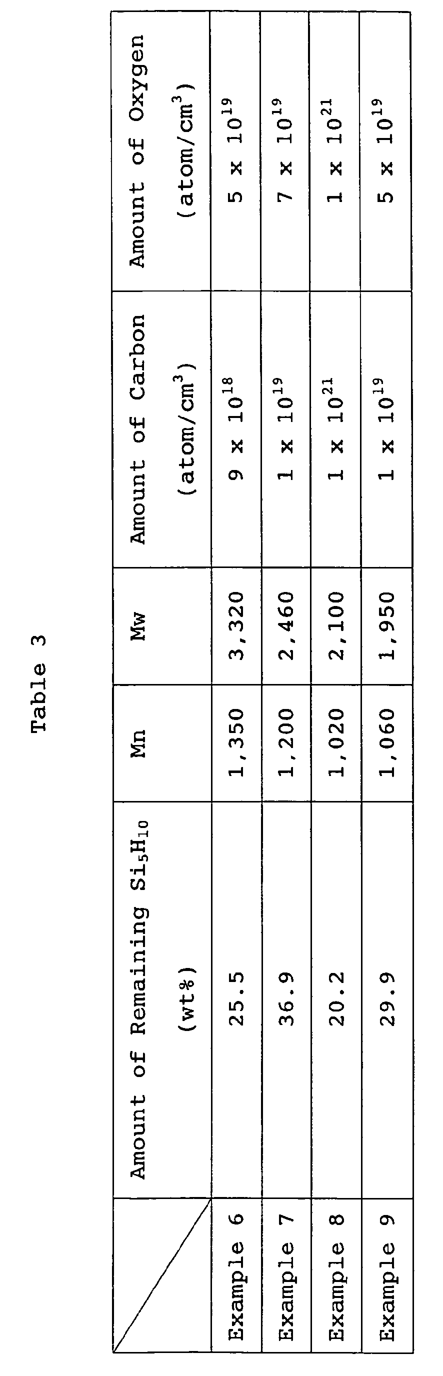

## Claims

1. A silane polymer having a weight average molecular weight in terms of polystyrene measured by gel permeation chromatography of 800 to 5,000.

2. A method for producing a silane polymer which comprises irradiating a photopolymerizable silane compound with light of specific wavelength range to produce the silane polymer of claim 1.

3. The method of claim 2, wherein the photopolymerizable silane compound is in the form of a liquid or solution.

4. The method of claim 2 or 3, wherein the photopolymerizable silane compound is at least one selected from the group consisting of a chain silane compound represented by the formula:
SiᵢX₂ᵢ₊₂
(wherein X is a hydrogen atom or a halogen atom, and i is an integer of 2 to 10),
a cyclic silane compound represented by the formula:
SiⱼX₂ⱼ
(wherein X is a hydrogen atom or a halogen atom, and j is an integer of 3 to 10),
a cyclic silane compound represented by the formula:
SiₘX₂ₘ₋₂
(wherein X is a hydrogen atom or a halogen atom, and m is an integer of 4 to 10),
and a basket-shaped silane compound represented by the formula:
SiₖXₖ
(wherein X is a hydrogen atom or a halogen atom, and k is 6, 8 or 10).

5. The method of claim 2, wherein the light of specific wavelength range comprises light having a wavelength of 300 to 420 nm.

6. The method of claim 2, wherein the irradiation time is 0.1 seconds to 600 minutes.

7. A silicon film forming composition comprising the silane polymer of claim 1 and an organic solvent.

8. The composition of claim 7, further comprising a material containing an element of the 3B group or a material containing an element of the 5B group in the periodic table.

9. A method for forming a silicon film which comprises applying the composition of claim 7 or 8 on a substrate and subjecting the resulting coating film to at least one of a heat treatment and a light treatment.

10. The method of claim 9, wherein the organic solvent contained in the composition is selectively removed before any of the heat treatment and the light treatment is carried out after the application.
